# EUROPÄISCHE PATENTSCHRIFT

(11) **EP 0 556 731 B1**
(45) Veröffentlichungstag und Bekanntmachung des Hinweises auf die Patenterteilung: **30.12.1998**
(21) Anmeldenummer: 93102192.7
(22) Anmeldetag: 12.02.1993
(51) Int. Cl.: G03F 7/029, G03F 3/10

(54) **Verfahren zur Herstellung eines Mehrfarbenbilds und lichtempfindliches Material zur Durchführung dieses Verfahrens**
Method of production of a multicolour image and photosensitive material for carrying out the method
Procédé de formation d'une image multicolore et matériau sensible à la lumière pour la mise en oeuvre dudit procédé

(30) Priorität: 19.02.1992 DE 4204949
(43) Veröffentlichungstag der Anmeldung: 25.08.1993
(73) Patentinhaber: Agfa-Gevaert AG, 51373 Leverkusen (DE)
(72) Erfinder: Platzer, Stephan J.W., Dr., W-6228 Eltville/Erbach (DE); Wilczak, Wojciech A., Dr., Jersey City, N.J. 07302 (US); Buhr, Gerhard, Dr., W-6240 Königstein 4 (DE); Mohr, Dieter, Dr., W-6501 Budenheim (DE)

(56) Entgegenhaltungen:
- EP-A- 0 352 055
- EP-A- 0 503 674
- US-A- 4 189 323

## Beschreibung

Die Erfindung betrifft ein lichtempfindliches, insbesondere photopolymerisierbares Material für die Herstellung von Farbprüffolien für den Mehrfarbendruck. Sie betrifft ferner ein Farbprüfverfahren, bei dem auf einem Bildempfangsmaterial ein Mehrfarbenbild aus mehreren Teilfarbenbildern im Register erzeugt wird. Die Teilfarbenbilder werden durch Laminieren einer in einer Grundfarbe eingefärbten photopolymerisierbaren Schicht auf das Bildempfangsmaterial, Belichten unter dem zugehörigen Farbauszug, Entwickeln des Bilds durch Abziehen der Trägerfolie der photopolymerisierbaren Schicht zusammen mit den Nichtbildstellen und Wiederholen der gleichen Schritte mit einer photopolymerisierbaren Schicht einer anderen Grundfarbe hergestellt.

Ein derartiges Farbprüfverfahren und ein hierfür vorgesehenes Material sind aus den US-A 4 895 787 und 5 049 476 bekannt. Dieses Material besteht aus einer transparenten Trägerfolie, deren Oberfläche vorzugsweise haftvermittelnd vorbehandelt worden ist, einer photopolymerisierbaren Schicht, die einen Farbstoff oder ein Farbpigment in einer Grundfarbe des Mehrfarbendrucks enthält und einer durch Erwärmen aktivierbaren Haftschicht auf der photopolymerisierbaren Schicht. Das Material wird nach Laminieren auf ein Bildempfangsmaterial und Belichten durch die Trägerfolie durch Auseinanderziehen ("peel apart") von Trägerfolie und Bildempfangsmaterial entwickelt, wobei die belichteten Bereiche der lichtempfindlichen Farbschicht an der Trägerfolie, die unbelichteten Bereiche zusammen mit der gesamten Haftschicht auf dem Bildempfangsmaterial verbleiben. Das Verfahren arbeitet also positiv, d. h. auf dem Bildempfangsmaterial entsteht ein positives Abbild der Vorlage.

Dieses Verarbeitungsverfahren hat den großen Vorteil, daß es zur Entwicklung keine alkalischen oder sauren Lösungen und keine organischen Lösemittel erfordert, deren Entsorgung damit entfällt. Ein Nachteil dieses Verfahrens ist die relativ geringe Lichtempfindlichkeit des dabei eingesetzten lichtempfindlichen Materials.

Die Lichtempfindlichkeit kann zwar durch Wahl eines aktiveren Photoinitiators verbessert werden, doch haben solche Initiatoren in der Regel eine höhere Lichtabsorption im sichtbaren Spektralbereich, die eine mehr oder weniger starke Verfärbung des Bildhintergrunds, d. h. der Nichtbildstellen, bewirkt, so daß der Farbeindruck des fertigen Mehrfarbenbilds hierbei verfälscht wird.

In der EP-A 0 503 674 ist ein Material zur Herstellung von ein- oder mehrfarbigen Colorproofs offenbart. Es umfaßt eine flexible Trägerfolie, die vorzugsweise durchlässig ist für aktinische Strahlung, und eine darauf befindliche abziehbare Schicht aus einem organischen Polymer. Auf diese nicht lichtempfindliche Schicht folgt dann eine photopolymerisierbare Schicht, die ein polymeres Bindemittel, eine radikalisch polymerisierbare Verbindung, einen Photoinitiator sowie ggf. auch einen Farbstoff oder ein Pigment enthält. Der Photoinitiator ist eine Verbindung mit zwei (4,6-Bis-trihalogenmethyl-[1, 3, 5]triazin-2-yl) -phenyl-Gruppen. Gegebenenfalls kann die photopolymerisierbare Schicht noch mit einer Schutzschicht versehen sein. Um ein farbiges Bild herzustellen, wird das Material bildmäßig bestrahlt. Allgemein geschieht das in einem Kontaktkopierverfahren durch Auflegen des entsprechenden Farbauszugs und Bestrahlen mit einer Quecksilber-Hochdruckdampflampe Die nicht bestrahlten und damit nicht gehärteten Bereiche der photopolymerisierbaren werden dann mit einem flüssigen Entwickler entfernt. Auf der abziehbaren Schicht bleibt auf diese Weise ein farbiges Bild zurück, bestehend aus den gehärteten Bereichen der photopolymerisierbaren Schicht. Mit der Bildseite wird dieses Material auf die photopolymerisierbare Schicht eines weiteren Zwischenträgers (im allgemeinen ebenfalls eine transparente Kunststoffolie) laminiert. Anschließend wird die erste Trägerfolie mit der Schicht abgezogen. Auf die gleiche Weise werden die Bilder in den anderen Teilfarben von dem ersten auf den zweiten Träger übertragen. Mit der Seite, auf der sich das (mehrfarbige) Bild befindet, wird das Material auf das endgültige Bildempfangsmaterial (meist ein Papierbogen) laminiert. Durch die Trägerfolie hindurch wird das Laminat anschließend ganzflächig bestrahlt. Dabei härtet die farblose photopolymerisierbare Schicht aus. Zum Schluß wird noch die Kunststoff-Trägerfolie abgezogen. Ein besonderer Vorteil dieses recht komplizierten Verfahrens wird darin gesehen, daß die Teilfarbenbilder bei niedriger Temperatur auf eine weiche, noch nicht gehärtete Photopolymerschicht übertragen werden. Im ausgehärteten Zustand verhindert diese Schicht Adhäsion und Rißbildung.

Aufgabe der Erfindung war es, ein lichtempfindliches Material und ein Farbprüfverfahren der eingangs beschriebenen Gattung zur Verfügung zu stellen, die eine höhere Lichtempfindlichkeit ohne Verfärbung des Bildhintergrunds ergeben.

Gegenstand der Erfindung ist ein lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
   B1) ein polymeres Bindemittel,
   B2) eine radikalisch polymerisierbare Verbindung,
   B3) eine Verbindung, die unter Einwirkung von aktinischem Licht die Polymerisation von (B2) einzuleiten vermag, und
   B4) einen Farbstoff oder ein Farbpigment in einer Grundfarbe des Mehrfarbendrucks enthält, und
C) einer thermoplastischen Haftschicht auf der lichtempfindlichen Schicht.

Das erfindungsgemäße Material ist dadurch gekennzeichnet, daß die Verbindung (B 3) ein substituiertes Bis-trihalogenmethyl-s-triazin mit einem Extinktionsmaximum im Bereich von 300 bis 380 nm und einem Extinktionskoeffizienten am Extinktionsmaximum von mehr als 11.000 sowie einem Extinktionskoeffizienten von weniger als 1.400 bei 400 nm und darüber ist.

Gemäß einem anderen Aspekt der Erfindung wird ein Verfahren zur Herstellung eines Mehrfarbenbilds vorgeschlagen, das dadurch gekennzeichnet ist, daß man ein lichtempfindliches Material der vorstehend angegebenen Zusammensetzung mit der Haftschicht unter Druck auf ein Bildempfangsmaterial laminiert, durch die Trägerfolie hindurch mit einem Farbauszug vor oder nach dem Laminieren bildmäßig belichtet, die Trägerfolie zusammen mit den belichteten Schichtbereichen von dem Bildempfangsmaterial abzieht und die Schritte Laminieren, Belichten und Abziehen mit mindestens einem weiteren Farbauszug wiederholt, wobei das Belichten im Register mit dem ersten auf dem Bildempfangsmaterial erzeugten Teilfarbenbild erfolgt.

Die photopolymerisierbare Schicht des erfindungsgemäßen Materials enthält als wesentliche Bestandteile ein polymeres Bindemittel, eine radikalisch polymerisierbare Verbindung, einen Photoinitiator vom Typ des Bis-trihalogenmethyl-s-triazins, insbesondere des Bis-trichlormethyl-s-triazins, und einen Farbstoff oder ein Farbpigment in einer Grundfarbe des Mehrfarbendrucks. Beispiele für photopolymerisierbare Schichten dieser allgemeinen Zusammensetzung sind in der US-A 4 895 787 beschrieben, auf die hier Bezug genommen werden soll.

Das Bis-trihalogenmethyl-s-triazin muß die vorstehend angegebenen Bedingungen erfüllen, d. h. es muß in dem Bereich von 300 bis 380 nm, vorzugsweise von 320 bis 350 nm, ein Extinktionsmaximum aufweisen und darf im Spektralbereich oberhalb 400 nm eine bestimmte Mindestextinktion nicht überschreiten.

Substituierte Trihalogenmethyltriazine des erfindungsgemäß einzusetzenden Typs sind bekannt und z. B. in der US-A 3 987 037 und 4 189 323 beschrieben. Von den dort beschriebenen Verbindungen sind jedoch nur diejenigen geeignet, die die vorstehend angegebenen Absorptionsbedingungen erfüllen. Diese Verbindungen sind in den Patentschriften, die Farbprüffolien der eingangs genannten Gattung beschreiben, nirgends erwähnt. Bevorzugt werden 2-Aryl- oder 2-Arylalkenyl-4,6-bis-trihalogenmethyl-s-triazine. Als Arylgruppen kommen ein- oder mehrkernige, insbesondere einkernige Aromaten in Betracht, die ggf. durch eine oder mehrere Alkyl-, Alkoxy-, Alkylendioxy-, Phenyl- oder Phenoxygruppen substituiert sein können. Als Arylalkenylgruppen werden Styrylgruppen bevorzugt, die ggf. gleiche Substituenten im aromatischen Kern tragen können. Die Menge des Photoinitiators liegt im allgemeinen zwischen 1 und 25, vorzugsweise zwischen 5 und 15 Gew.-%, bezogen auf die feste Schicht.

Das polymere Bindemittel soll der Schicht Homogenität und Festigkeit verleihen. Geeignete Bindemittel sind Styrol/Maleinsäureanhydrid- und Styrol/Maleinsäurehalbester-Copolymere, Acrylesterpolymere und -copolymere, Polyamide, Polyvinylpyrrolidone, Cellulosederivate, wie Celluloseester und -ether, Phenolharze, Polyvinylester, Polyvinylacetale, z. B. Polyvinylbutyral, -propional oder -formal. Der Mengenanteil des Bindemittels beträgt im allgemeinen 15 bis 70, vorzugsweise 20 bis 50 Gew.-%, bezogen auf das Gewicht der festen Schicht.

Die polymerisierbare Verbindung enthält mindestens eine, bevorzugt mindestens zwei endständige radikalisch polymerisierbare Doppelbindungen und ist bei Temperaturen unterhalb 100 °C und bei Normaldruck nicht gasförmig. Bevorzugt werden Ester und Amide der Acryl- und Methacrylsäure. Besonders die Ester mit mehrwertigen Alkoholen werden mit Vorteil eingesetzt. Beispiele sind Di-, Tri-, Tetra- und Polyethylenglykoldi(meth)acrylat, die Di(meth)acrylate von Oligo- und Polypropylenglykolen, 1,4-Butandioldi(meth)acrylat, Trimethylolpropan- und Trimethylolethandi- und -tri(meth)acrylat, Pentaerythrittri- und -tetraacrylat oder -methacylat, Dipentaerythrittetra-, -penta- und -hexa(meth)acrylat.

Der Mengenanteil an polymerisierbarer Verbindung beträgt im allgemeinen 15 bis 70, vorzugsweise 20 bis 60 Gew.-%.

Die Farbstoffe bzw. Farbpigmente werden so ausgewählt, daß sie den Grundfarben des Mehrfarbendrucks, Cyan (Blaugrün); Magenta (Purpur); Gelb und Schwarz, entsprechen. Pigmente werden im allgemeinen bevorzugt. Beispiele sind Permanentgelb G (C.I. 21 095), Permanent-gelb GR (C.I. 21 100), Permanentgelb DHG (C.I. 21 090), Permanentrubin L6B (C.I. 15 850 : 1), Permanent Pink F3B (C.I. 12 433), Hostaperm Pink E (C.I. 73 915), Hostaperm Rotviolett ER (C.I. 46 500), Permanentkarmin FBB (C.I. 12 485), Hostapermblau B2G (C.I. 74 160), Hostapermblau A2R (C.I. 74 160) und Printex^{(R)} 25 (Ruß). Die Pigmente können ggf. zur Erzielung des gewünschten Farbtons abgemischt werden. Die anorganischen oder organischen Pigmente werden im allgemeinen zusammen mit einem Teil des Bindemittels in einem geeigneten Lösemittel dispergiert oder angeteigt. Die mittlere Partikelgröße liegt i. a. unterhalb 1 µm.

Der Mengenanteil des Farbstoffs oder Pigments beträgt im allgemeinen 8 bis 40, vorzugsweise 12 bis 30 Gew.-%.

Die photopolymerisierbare Schicht kann ggf. weitere Bestandteile, wie Wasserstoffdonatoren, Sensibilisatoren, Polymerisationsinhibitoren, Weichmacher, Restlöser, Tenside, Oberflächenausgleichsmittel, Gleitmittel, Antistatika, inerte Füllstoffe, optische Aufheller und/oder UV-Absorber, enthalten. Sie hat im allgemeinen ein Schichtgewicht von 0,2 bis 5, bevorzugt 0,3 bis 3 g/m².

Nach dem Trocknen der photopolymerisierbaren Schicht wird auf diese eine wärmeaktivierbare thermoplastische Haftschicht aufgebracht. Diese kann entweder aus einem Lösemittel oder Lösemittelgemisch, das die photopolymerisierbare Schicht nicht anlöst, direkt auf diese aufgebracht und getrocknet werden. Sie kann auch zuerst auf eine temporäre Trägerfolie aufgebracht und von dort durch Laminieren und Abziehen der Trägerfolie auf die photopolymerisierbare Farbschicht übertragen werden. Gemäß einer anderen Ausführungsform kann die Haftschicht durch Beschichten des Bildempfangsmaterials aus einem Lösemittel und Trocknen erhalten werden. Auf die so erhaltene Haftschicht wird dann die photopolymerisierbare Schicht durch Laminieren übertragen. Das direkte Aufbringen aus Lösemitteln auf die photopolymerisierbare Schicht wird bevorzugt. Geeignete Lösemittel, die die Farbschicht nicht anlösen, sind Wasser und gesättigte Kohlenwasserstoffe. Viele Polymere können aus wäßriger Dispersion aufgebracht werden; das Aufbringen aus Lösung wird aber bevorzugt. Hierfür eignen sich z. B. Salze von Polymerem mit Säuregruppen, z. B. Carboxylgruppen. Ein bevorzugtes Beispiel ist eine wäßrig-alkalische Lösung eines Vinylacetat/Crotonsäure-Copolymeren (Mowilith Ct 5). Andere geeignete Polymere sind Polyvinylacetat- oder Polyacrylatdispersionen. Das Polymere sollte eine Erweichungstemperatur im Bereich von 40 bis 200, vorzugsweise von 60 bis 120 °C haben. Die Haftschicht kann außer dem thermoplastischen Polymeren noch Weichmacher, Restlöser, Oberflächenausgleichsmittel, Gleitmittel, Antistatika, optische Aufheller und/oder UV-Absorber enthalten. Ihr Schichtgewicht im trockenen Zustand beträgt normalerweise 2 bis 30, vorzugsweise 4 bis 15 g/m². Geeignete Haftschichten sind auch in der US-A 4 895 787 beschrieben.

Als Trägerfolien werden transparente, flexible, dimensionsstabile Folien aus Kunststoffen, z. B. Polyestern, Polycarbonaten usw., eingesetzt. Besonders bevorzugt werden Polyesterfolien, insbesondere biaxial verstreckte und wärmefixierte Folien, z. B. aus Polyethylenterephthalat. Diese sollten bei den erforderlichen Laminiertemperaturen, d. h. von etwa 60 bis 150 °C maßhaltig bleiben. Ihre Dicke beträgt im allgemeinen 10 bis 200, vorzugsweise 25 bis 80 *µ*m. Die Trägerfolie wird vorteilhaft ein- oder beidseitig haftvermittelnd vorbehandelt und kann eine glatte oder eine rauhe bzw. matte, vorzugsweise eine glatte Oberfläche haben.

Zur Durchführung des erfindungsgemäßen Verfahrens wird das oben beschriebene lichtempfindliche Material mit der Haftschicht auf ein Bildempfangsmaterial laminiert. Dieses kann aus Kunststoff, kunststoffbeschichtetem Spezialpapier oder aus normalem Bedruckpapier bestehen. Andere weiße und ggf. auch nicht-weiße Empfangsmaterialien können ebenfalls verwendet werden. Ein unter den Laminierbedingungen maßhaltiges Bedruckpapier wird gewöhnlich bevorzugt, da damit ein dem späteren Druck weitgehend nahekommender visueller Eindruck erzielt wird. Das Laminieren erfolgt zweckmäßig in einem hierfür vorgesehenen Gerät unter Druck und bei erhöhter Temperatur. Die Laminiertemperatur liegt gewöhnlich im Bereich von 60 bis 130, bevorzugt zwischen 70 und 100 °C. Vor oder bevorzugt nach dem Laminieren wird die photopolymerisierbare Schicht durch die Trägerfolie hindurch bildmäßig, i. a. im Kontakt unter einem Positiv-Farbauszug, in bekannter Weise belichtet. Nach dem Belichten wird die Trägerfolie mit der Hand oder in einer geeigneten Vorrichtung abgezogen. Der Abziehwinkel sollte mindestens 90° betragen, ein Winkel von 180° wird besonders bevorzugt. Dabei werden die belichteten Bereiche der photopolymerisierbaren Schicht mit der Trägerfolie entfernt, während die unbelichteten zusammen mit der gesamten Haftschicht auf dem Bildempfangsmaterial verbleiben. Auf diese Weise wird ein positives Teilfarbenbild erhalten. Jede weitere Farbprüffolie wird in der beschriebenen Weise auf das vorangehende Teilfarbenbild laminiert, dort im Register belichtet und durch Abziehen der Trägerfolie entwickelt. So wird aus den Teilfarbenbildern der Farben Cyan (Blaugrün), Magenta (Purpur), Gelb und Schwarz ein vollständiges Mehrfarbenbild erzeugt, das dem späteren 4-Farben-Druckbild entspricht. Bei Bedarf können selbstverständlich auch Farbprüffolien in Sonderfarben eingesetzt werden.

Das fertige Mehrfarbenbild hat eine glänzende Oberfläche. Nach Wunsch kann die Oberfläche mattiert werden, indem z. B. eine Folie mit rauher Oberfläche auf die glänzende Schichtoberfläche laminiert und wieder abgezogen wird. Die Oberfläche des fertigen Prüfbilds kann mit einer Schutzschicht gegen Verkratzen oder Verkleben bei höheren Temperaturen geschützt werden.

Die Erfindung wird durch die folgenden Beispiele erläutert. Alle Prozentangaben und Mengenverhältnisse sind in Gewichtseinheiten zu verstehen.

### Beispiele 1 bis 13

Beschichtungslösungen der folgenden Zusammensetzung wurden auf 50 *µ*m dicke biaxial verstreckte und thermofixierte Polyethylenterephthalatfolien, die auf beiden Seiten zur Haftverbesserung vorbehandelt waren (Melinex^{(R)} 454) aufgebracht und getrocknet:

| | |
|---|---|
| 35,4 Gt | Dipentaerythritpentaacrylat, |
| 36,5 Gt | Polyvinylformal (Formvar^{(R)} 12/85), |
| 18,5 Gt | Permanentcarmin FBB (C.I. 12 485), |
| 0,6 Gt | Silikonöl als Verlaufmittel (Edaplan^{(R)} LA 411) und |
| 7,8 Gt | Photoinitiator wie in Tabelle 1 in |
| 1000 Gt | Tetrahydrofuran, |
| 680 Gt | 1-Methoxy-propan-2-ol und |
| 190 Gt | Butyrolacton |

Die trockene Schicht hatte ein Gewicht von 0,83 g/m². Auf diese Schicht wurde eine Lösung von

| | |
|---|---|
| 96,7 Gt | Vinylacetat/Crotonsäure-Mischpolymerisat (95:5), |
| 1,9 Gt | Polyvinylmethylether (Lutonal^{(R)} M 40) und |
| 1,4 Gt | Natriumsulfit in |
| 520 Gt | Wasser, |
| 43 Gt | Ethanol und |
| 8,5 Gt | wäßrigem Ammoniak (25 %) |

aufgestrichen und getrocknet. Die erhaltene trockene Haftschicht hatte ein Gewicht von 6,5 g/m².

Das erhaltene lichtempfindliche Material wurde mit der Haftschicht auf ein Empfangsblatt aus Papier laminiert, durch die Trägerfolie hindurch unter einem Purpurfarbauszug belichtet und durch Auseinanderziehen von Folie und Empfangsblatt entwickelt. Dabei verblieb auf dem Empfangsblatt ein positives Purpur-Teilfarbenbild der Vorlage.

### Vergleichsbeispiele A bis H

Lichtempfindliche Farbprüffolien wurden in der gleichen Weise wie in den Beispielen 1 bis 13 hergestellt und zu Teilfarbenbildern verarbeitet. Dabei wurden die in Tabelle 1 angegebenen bekannten Photoinitiatoren zum Vergleich eingesetzt.

In der Tabelle 1 sind die für eine optimale Auflösung erforderliche Belichtungszeit, der Grad der Hintergrundverfärbung, das Absorptionsmaximum des Photoinitiators (λₘₐₓ), der molare Extinktionskoeffizient bei dieser Wellenlänge (εₘₐₓ) und der molare Extinktionskoeffizient bei 400 nm (ε₄₀₀) angegeben. Die Hintergrundverfärbung ist relativ zu der gelblichen Verfärbung bei Vergleichsbeispiel D angegeben, wobei O den gleichen Verfärbungsgrad, + eine särkere, - eine geringere Verfärbung bedeutet.

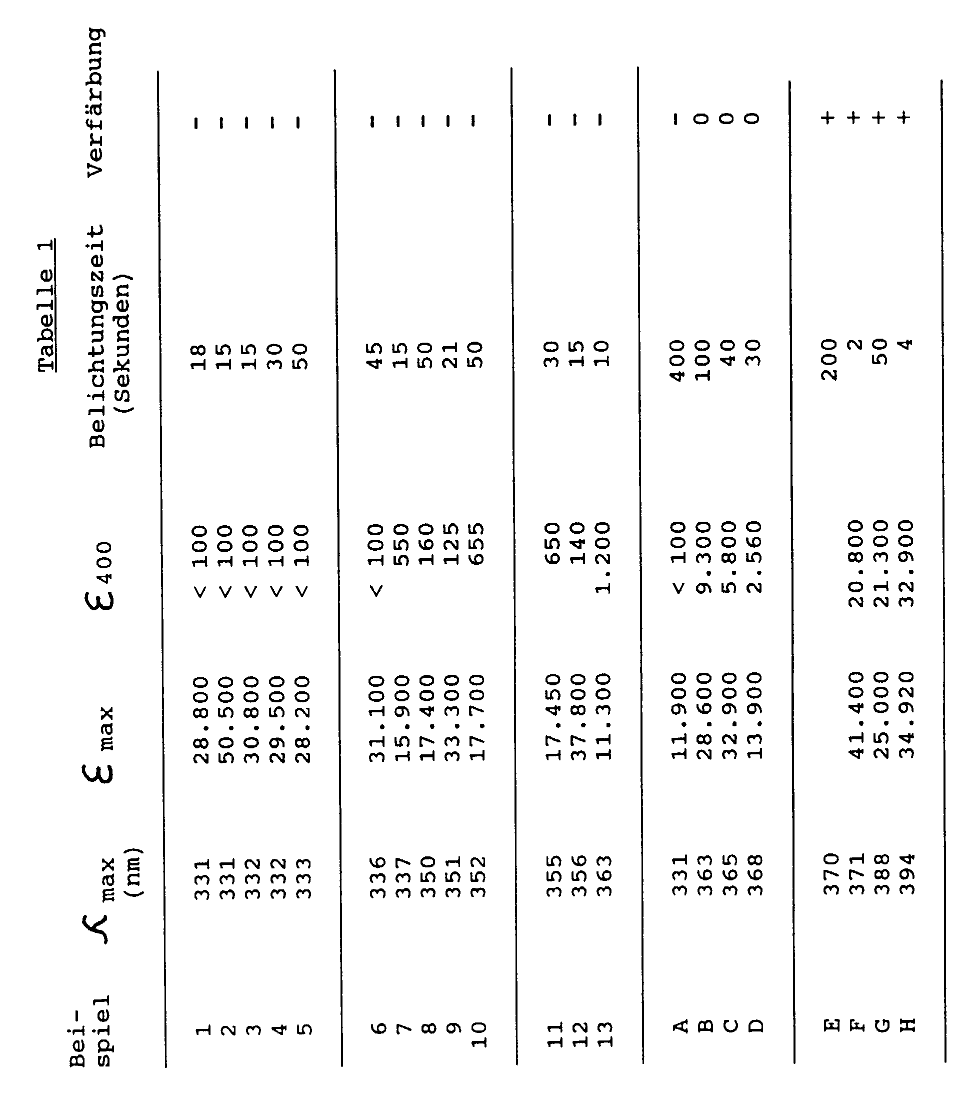

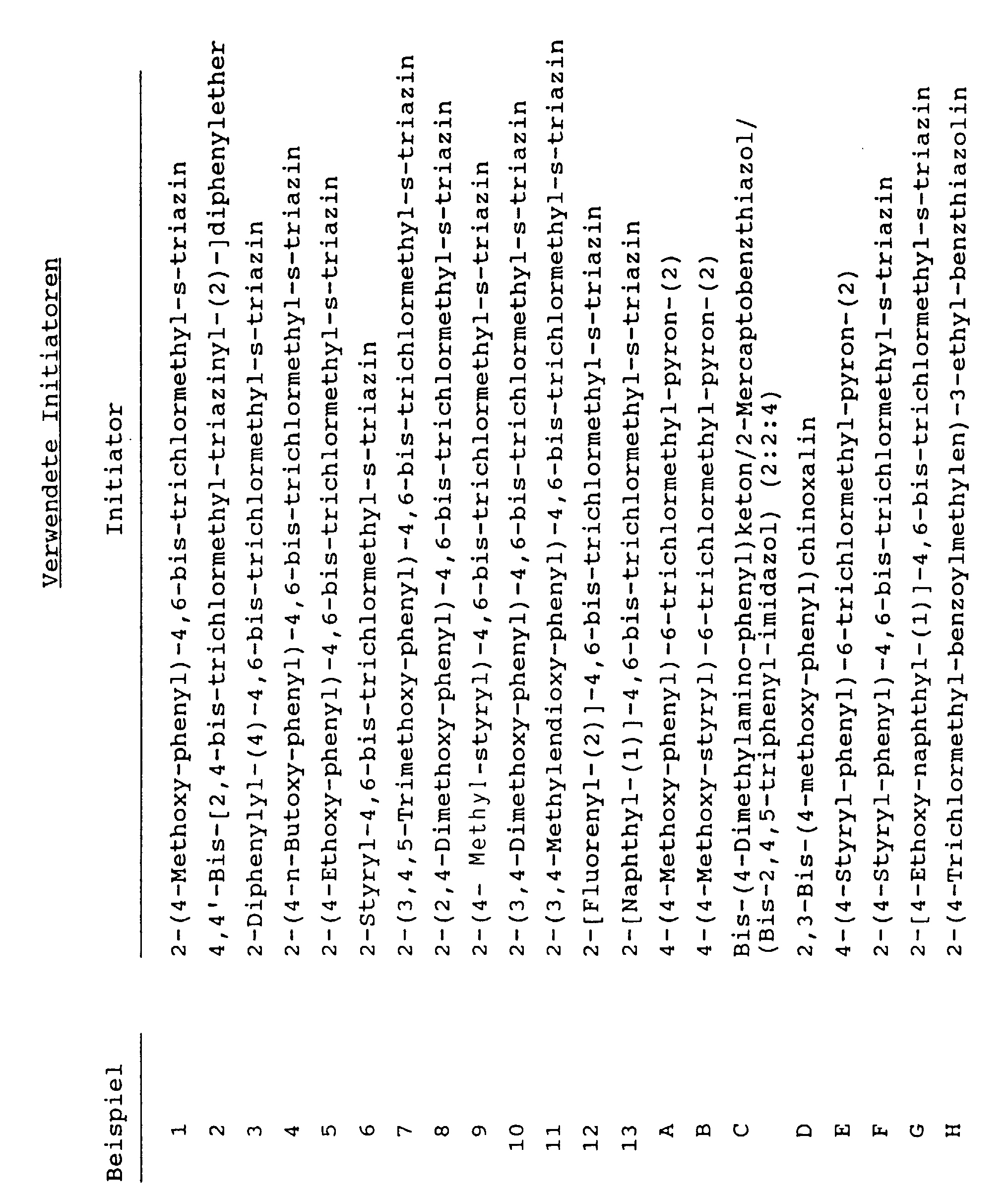

Die Hintergrundverfärbung hängt ab von der Menge des Initiators und seiner Absorption im sichtbaren Spektralbereich, etwa von 400 bis 700 nm. Bei gleicher Menge wird die Verfärbung in erster Näherung durch den Extinktionskoeffizienten bei 400 nm bestimmt. Der Hintergrund ist bei Initiatoren mit ε₄₀₀-Werten unterhalb etwa 1400 im allgemeinen farblos. Bei Initiatoren mit ε₄₀₀-Werten von etwa 1400 bis 8000 ist eine leichte Gelbfärbung erkennbar. Bei Werten oberhalb 8000 ist die Verfärbung deutlich und das Bild für eine Farbprüfung nicht geeignet.

Das Gemisch von Vergleichsbeispiel C entspricht der Initiatorkombination von Beispiel 6 der US-A 5 049 476. Die in der Tabelle angegebenen Werte für λₘₐₓ und ε sind die von Bis-(4-Dimethylamino-phenyl)keton.

### Beispiel 14

Zur Herstellung von Farbprüffolien in den vier Grundfarben wurden die folgenden Lösungen

| Bestandteil | Gewichtsteile | | | |
|---|---|---|---|---|
| | Blaugrün | Purpur | Gelb | Schwarz |
| Dipentaerythritpentaacrylat | 39,0 | 35,5 | 38,2 | 36,1 |
| Polyvinylformal (Formvar^{(R)} 12/85) | 31,3 | 36,5 | 35,4 | 28,9 |
| 2-Diphenylyl-(4)-4,6-bis-trichlormethyl-s-triazin | 9,8 | 7,8 | 9,5 | 9,6 |
| Hostapermblau B2G (C.I.74160) | 19,0 | -- | -- | -- |
| Permanentcarmin FBB (C.I.12485) | -- | 18,5 | -- | -- |
| Permanentgelb GR (C.I.21100) | -- | 0,7 | 16,4 | -- |
| Ruß (Printex^{(R)} 25 | 0,4 | 0,5 | -- | 24,8 |
| Silikonöl wie in Beispiel 1 | 0,5 | 0,5 | 0,5 | 0,6 |
| Tetrahydrofuran | 1000 | 1000 | 1000 | 1000 |
| 1-Methoxy-propan-2-ol | 680 | 680 | 680 | 680 |
| Butyrolacton | 190 | 190 | 190 | 190 |

auf Polyesterfolien wie in den Beispielen 1-13 angegeben aufgebracht und getrocknet. Die Farbpigmente wurden zuerst in einer Lösung eines Teils des Polyvinylformals in Butyrolacton dispergiert und zu einer mittleren Teilchengröße von weniger als 0,2 µm vermahlen. Das Trockenschichtgewicht der vier Folien war wie folgt:

| | |
|---|---|
| Blaugrün | 0,58 g/m² |
| Purpur | 0,83 " |
| Gelb | 0,75 " |
| Schwarz | 0,67 " |

Auf die lichtempfindliche Schicht wurde jeweils eine Haftschichtlösung der in den Beispielen 1 - 13 angegebenen Zusammensetzung aufgebracht und zu einem Schichtgewicht von 6,5 g/m² getrocknet.

Die Blaugrünfolie wurde mit der Haftschicht bei 85 °C auf ein Empfangsblatt aus Papier laminiert und unter einem Blaugrün-Farbauszug durch die Trägerfolie hindurch belichtet. Dann wurde die Trägerfolie von dem Empfangsblatt abgezogen, wobei die unbelichteten Schichtbereiche auf dem Empfangsblatt zurückblieben. In gleicher Weise wurden nacheinander die Purpur-, Gelb- und Schwarzfolie auf das Empfangsblatt über das vorhergehende Teilfarbenbild laminiert, unter dem entsprechenden Farbauszug belichtet und durch Abziehen der Trägerfolie entwickelt. Auf diese Weise wurde ein Vierfarbenbild auf dem Empfangsblatt erhalten, das der ursprünglichen Vorlage entsprach. Die Auflösung betrug - unabhängig von der Abzugsrichtung der Trägerfolie - mindestens 15 *µ*m. In einem Raster von 60 Linien/cm wurden die Rasterpunkte von 2 bis 98 % wiedergegeben. Die erforderlichen Belichtungszeiten waren 16 Sekunden für Blaugrün, 10 Sekunden für Purpur, 12 Sekunden für Gelb und 24 Sekunden für Schwarz. Der Hintergrund des Vierfarben-Prüfbilds hatte eine optische Dichte von 0,02, gemessen mit dem Gelbfilter eines Densitometers.

### Vergleichsbeispiel I

Beispiel 14 wurde wiederholt, wobei das dort eingesetzte Trichlormethyltriazin durch das im Verbleichsbeispiel D angegebene Chinoxalin ersetzt wurde. Die Belichtungszeiten waren 32 Sekunden für Blaugrün, 24 Sekunden für Purpur, 32 Sekunden für Gelb und 64 Sekunden für Schwarz. Der Hintergrund des Vierfarbenbilds hatte eine optische Dichte von 0,05.

## Patentansprüche

1. Lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
B1) ein polymeres Bindemittel,
B2) eine radikalisch polymerisierbare Verbindung,
B3) eine Verbindung, die unter Einwirkung von aktinischem Licht die Polymerisation von (B2) einzuleiten vermag, und
B4) einen Farbstoff oder ein Farbpigment in einer Grundfarbe des Mehrfarbendrucks enthält, und
C) einer thermoplastischen Haftschicht auf der lichtempfindlichen Schicht,
dadurch gekennzeichnet, daß die Verbindung (B 3) ein substituiertes Bis-trihalogenmethyl-s-triazin mit einem Extinktionsmaximum im Bereich von 300 bis 380 nm und einem Extinktionskoeffizienten am Extinktionsmaximum von mehr als 11.000 sowie einem Extinktionskoeffizienten von weniger als 1400 bei 400 nm und darüber ist.

2. Lichtempfindliches Material nach Anspruch 1, dadurch gekennzeichnet, daß das Extinktionsmaximum der Verbindung (B 3) im Bereich von 320 bis 350 nm liegt.

3. Lichtempfindliches Material nach Anspruch 1, dadurch gekennzeichnet, daß die Verbindung (B 3) ein 2-Aryl- oder 2-Aryl-alkenyl-4,6-bis-trichlormethyl-s-triazin ist.

4. Lichtempfindliches Material nach Anspruch 1, dadurch gekennzeichnet, daß die radikalisch polymerisierbare Verbindung mindestens zwei polymerisierbare Gruppen enthält.

5. Lichtempfindliches Material nach Anspruch 1, dadurch gekennzeichnet, daß die radikalisch polymerisierbare Verbindung ein Acryl- oder Methacrylsäureester ist.

6. Lichtempfindliches Material nach Anspruch 1, dadurch gekennzeichnet, daß die thermoplastische Haftschicht eine Glastemperatur Tg von 20 bis 100 °C hat.

7. Lichtempfindliches Material nach Anspruch 1, dadurch gekennzeichnet, daß die thermoplastische Haftschicht ein Gewicht von 2 bis 30 g/m² hat.

8. Lichtempfindliches Material nach Anspruch 1, dadurch gekennzeichnet, daß die photopolymerisierbare Schicht ein Gewicht von 0,2 bis 5 g/m² hat.

9. Verfahren zur Herstellung eines Mehrfarbenbilds, dadurch gekennzeichnet, daß man ein lichtempfindliches Material der in Anspruch 1 angegebenen Zusammensetzung mit der Haftschicht unter Druck auf ein Bildempfangsmaterial laminiert, durch die Trägerfolie hindurch mit einem Farbauszug vor oder nach dem Laminieren bildmäßig belichtet, die Trägerfolie zusammen mit den belichteten Schichtbereichen von dem Bildempfangsmaterial abzieht und die Schritte Laminieren, Belichten und Abziehen mit mindestens einem weiteren Farbauszug wiederholt, wobei das Belichten im Register mit dem ersten auf dem Bildempfangsmaterial erzeugten Teilfarbenbild erfolgt.

10. Verfahren nach Anspruch 9, dadurch gekennzeichnet, daß das Bildempfangsmaterial Papier ist.

11. Verfahren nach Anspruch 10, dadurch gekennzeichnet, daß das Papier ein übliches Bedruckpapier ist, wie es für den Auflagendruck mit den entsprechenden Flachdruckplatten eingesetzt wird.

## Claims

1. A light-sensitive material for the production of colour test films for multi-colour printing, having
A) a transparent, flexible backing film made of plastic,
B) a photopolymerisable layer, which contains
B1) a polymeric binder,
B2) a compound which is polymerisable by a radical mechanism,
B3) a compound which is capable of initiating the polymerisation of (B2) under the effect of actinic light, and
B4) a dye or a colouring pigment in a primary colour of the multi-colour print, and
C) a thermoplastic adhesive layer on the light-sensitive layer,
characterised in that compound (B3) is a substituted bis-trihalogenomethyl-s-triazine with an extinction maximum within the range from 300 to 380 nm and an extinction coefficient of more than 11,000 at the extinction maximum, and with an extinction coefficient of less than 1400 at 400 nm and above.

2. A light-sensitive material according to claim 1, characterised in that the extinction maximum of compound (B3) falls within the range from 320 to 350 nm.

3. A light-sensitive material according to claim 1, characterised in that compound (B3) is a 2-aryl- or 2-aryl-alkenyl-4,6-bis-trichloromethyl-s-triazine.

4. A light-sensitive material according to claim 1, characterised in that the compound which is polymerisable by a radical mechanism contains at least two polymerisable groups.

5. A light-sensitive material according to claim 1, characterised in that the compound which is polymerisable by a radical mechanism is an ester of acrylic or methacrylic acid.

6. A light-sensitive material according to claim 1, characterised in that the thermoplastic adhesive layer has a glass transition temperature Tg of 20 to 100°C.

7. A light-sensitive material according to claim 1, characterised in that the thermoplastic adhesive layer has a weight of 2 to 30 g/m².

8. A light-sensitive material according to claim 1, characterised in that the photopolymerisable layer has a weight of 0.2 to 5 g/m².

9. A method of producing a multi-colour image, characterised in that a light-sensitive material of the composition given in claim 1 is laminated under pressure with its adhesive layer on to an image-receiving material, is exposed through the backing layer before or after lamination to form an image with a colour separation, the backing film, together with the exposed layer regions, is stripped from the image-receiving material, and the steps of laminating, exposure and stripping are repeated with at least one further colour separation, wherein exposure is effected in register with the first partial colour image produced on the image-receiving material.

10. A method according to claim 9, characterised in that the image-receiving material is paper.

11. A method according to claim 10, characterised in that the paper is a customary printing paper, such as that which is used for copy printing with corresponding flat bed printing plates.

## Revendications

1. Matériau photosensible pour la fabrication de feuilles-échantillons en couleurs pour la préparation d'imprimés polychromes, comprenant
A) une feuille de support flexible transparente en matière synthétique,
B) une couche photopolymérisable qui contient
B1) un liant polymère,
B2) un composé polymérisable par voie radicalaire,
B3) un composé qui, sous l'influence de la lumière actinique, a le pouvoir de déclencher la polymérisation de B2), et
B4) un colorant ou un pigment coloré en une couleur primaire de l'imprimé polychrome, et
C) une couche adhésive thermoplastique sur la couche photosensible,
caractérisé en ce que le composé (B3) représente une bis-trihalogénométhyl-s-triazine substituée possédant une extinction maximale dans le domaine de 300 à 380 nm et un coefficient d'extinction à l'extinction maximale supérieur à 11.000, ainsi qu'un coefficient d'extinction inférieur à 1.400 à 400 nm et au-delà.

2. Matériau photosensible selon la revendication 1, caractérisé en ce que l'extinction maximale du composé (B3) se situe dans le domaine de 320 à 350 nm.

3. Matériau photosensible selon la revendication 1, caractérisé en ce que le composé (B3) est une 2-aryl- ou une 2-arylalcényl-4,6-bis-trichlorométhyl-s-triazine.

4. Matériau photosensible selon la revendication 1, caractérisé en ce que le composé polymérisable par voie radicalaire contient au moins deux groupes polymérisables.

5. Matériau photosensible selon la revendication 1, caractérisé en ce que le composé polymérisable par voie radicalaire est un ester d'acide acrylique ou d'acide méthacrylique.

6. Matériau photosensible selon la revendication 1, caractérisé en ce que la couche adhésive thermoplastique possède une température de transition vitreuse (Tg) de 20 à 100°C.

7. Matériau photosensible selon la revendication 1, caractérisé en ce que la feuille adhésive thermoplastique possède un poids de 2 à 30 g/m².

8. Matériau photosensible selon la revendication 1, caractérisé en ce que la couche photopolymérisable possède un poids de 0,2 à 5 g/m².

9. Procédé pour la fabrication d'une image en couleurs, caractérisé en ce qu'on stratifie un matériau photosensible dont la composition est indiquée à la revendication 1, avec la couche adhésive, sous pression, sur un matériau récepteur d'image; on procède à une exposition en forme d'image à travers toute la feuille de support avec une sélection de couleur avant ou après la stratification; on pellicule du matériau récepteur d'image la feuille de support conjointement avec les zones de couches exposées; et on répète les étapes de stratification, d'exposition et de pelliculage avec au moins une autre sélection de couleur, l'exposition étant réalisée en repérage avec la première image de sélection partielle formée sur le matériau récepteur d'image.

10. Procédé selon la revendication 9, caractérisé en ce que le matériau récepteur d'image est du papier.

11. Procédé selon la revendication 10, caractérisé en ce que le papier est un papier d'impression habituel tel qu'on le met en oeuvre pour l'impression par tirage avec les clichés offset correspondants.
